# EUROPEAN PATENT APPLICATION

(11) **EP 4 310 107 A1**
(43) Date of publication of application: **24.01.2024**
(21) Application number: 22771335.1
(22) Date of filing: 11.03.2022
(51) Int. Cl.: C08F 2/50, B29C 59/02, C08F 2/44, H01L 21/027

(54) **PHOTOCURABLE COMPOSITION AND PATTERN FORMATION METHOD**

(30) Priority: 16.03.2021 JP 2021042611
(71) Applicant: TOKYO OHKA KOGYO CO., LTD., Kawasaki-shi, Kanagawa 211 0012 (JP)
(72) Inventor: KONNO Kenri, Kawasaki-shi, Kanagawa 211-0012 (JP); MORI Risako, Kawasaki-shi, Kanagawa 211-0012 (JP)
(74) Representative: Plasseraud IP
(86) International application number: PCT/JP2022/011103
(87) International publication number: WO 2022/196588

(57) **Abstract**

A photocurable composition containing metal oxide nanoparticles (X), a photopolymerizable compound (B), and a photoradical polymerization initiator (C), in which the content of the photoradical polymerization initiator (C) is 10 parts by mass or more with respect to 100 parts by mass of the total content of the metal oxide nanoparticles (X) and the photopolymerizable compound (B).

## Description

### [Technical Field]

The present invention relates to a photocurable composition and a pattern-forming method.

Priority is claimed on Japanese Patent Application No. 2021-042611, filed March 16, 2021, the content of which is incorporated herein by reference.

### [Background Art]

Lithography technology is a core technology in a process of manufacturing semiconductor devices, and with the recent increase in the integration of semiconductor integrated circuits (IC), further miniaturization of a wiring is in progress. Typical examples of the miniaturization method include shortening the wavelength of a light source using a light source having a shorter wavelength such as a KrF excimer laser, an ArF excimer laser, an F₂ laser, extreme ultraviolet light (EUV), an electron beam (EB), or X-rays, and increasing the diameter of a numerical aperture (NA) (increasing the NA) of a lens of an exposure device.

Under the above-described circumstances, nanoimprint lithography, which is a method for pressing a mold having a predetermined pattern against a curable film formed on a substrate so that the pattern of the mold is transferred to the curable film, is expected as a fine pattern-forming method for a semiconductor from the viewpoint of productivity.

In the nanoimprint lithography, a photocurable composition containing a photocurable compound that is cured by light (ultraviolet rays or electron beams) is used. In such a case, a transfer pattern (structure) is obtained by pressing a mold having a predetermined pattern against a curable film including a photocurable compound, irradiating the curable film with light to cure the photocurable compound, and then peeling off the mold from the cured film.

Examples of characteristics required for a photocurable composition used for the nanoimprint lithography include coatability in a case where the composition is applied onto a substrate through spin coating or the like; and curability in a case where the composition is heated or exposed. In a case where the coatability on the substrate is poor, the film thickness of the photocurable composition applied onto the substrate is uneven and the pattern transferability is likely to be degraded in a case where a mold is pressed against the curable film. In addition, the curability is an important property for maintaining the pattern formed by pressing the mold to have desired dimensions. Further, the photocurable composition is also required to have good mold releasability in a case where the mold is peeled off from the cured film.

In recent years, the application of nanoimprint lithography for enhancing the functionality of 3D sensors for autonomous driving and augmented reality (AR) waveguides for AR glasses has been examined. In the 3D sensors and the AR glasses, it is required to increase the refractive index of a permanent film material constituting a part of the device. As one means for increasing the refractive index of a nanoimprint material, the addition of metal oxide nanoparticles is known. For example, Patent Document 1 describes a photocurable resin composition in which a high refractive index is achieved by blending nanoparticles of metal oxides such as titanium oxide and zirconium oxide.

### [Citation List]

### [Patent Document]

[Patent Document 1]
Japanese Patent No. 5952040

### [Summary of Invention]

### [Technical Problem]

Increasing the content of metal oxide nanoparticles or increasing the particle diameter of the metal oxide nanoparticles to further increase the refractive index of a nanoimprint material has been considered. However, in a case where the refractive index is increased by increasing the particle diameter, there is a problem in that the haze in a visible light region is deteriorated.

The present invention has been made in consideration of the circumstances, and has an object to provide a photocurable composition having a high refractive index and a reduced haze; and a pattern-forming method.

### [Solution to Problem]

In order to accomplish the object, the present invention employs the following configurations.

That is, a first aspect of the present invention is a photocurable composition containing metal oxide nanoparticles (X), a photopolymerizable compound (B), and a photoradical polymerization initiator (C), in which the content of the photoradical polymerization initiator (C) is 10 parts by mass or more with respect to 100 parts by mass of the total content of the metal oxide nanoparticles (X) and the photopolymerizable compound (B).

A second aspect of the present invention is a pattern-forming method including a step of forming a photocurable film on a substrate using the photocurable composition according to the first aspect, a step of pressing a mold having an uneven pattern against the photocurable film to transfer the uneven pattern to the photocurable film, a step of exposing the photocurable film to which the uneven pattern has been transferred while pressing the mold against the photocurable film to form a cured film, and a step of peeling off the mold from the cured film.

### [Advantageous Effects of Invention]

According to the present invention, it is possible to provide a photocurable composition having a high refractive index and a reduced haze; and a pattern-forming method.

### [Brief Description of Drawings]

FIG. 1 is a schematic process chart describing an embodiment of a nanoimprint pattern-forming method.
FIG. 2 is a schematic process chart describing an example of an optional step.

### [Description of Embodiments]

In the present specification and the scope of the present patent claims, the term "aliphatic" is a relative concept used with respect to the term "aromatic" and defines a group or compound that has no aromaticity.

The term "alkyl group" includes a monovalent saturated hydrocarbon group that is linear, branched, or cyclic, unless otherwise specified. The same applies to an alkyl group in an alkoxy group.

The term "(meth)acrylate" means at least one of acrylate and methacrylate.

The phrase "may have a substituent" includes both a case where a hydrogen atom (-H) is substituted with a monovalent group and a case where a methylene group (-CH₂-) is substituted with a divalent group.

The term "exposure" is used as a general concept that includes irradiation with any form of radiation.

### (Photocurable Composition)

The photocurable composition of the first aspect of the present invention contains metal oxide nanoparticles (X) (hereinafter also referred to as a "component (X)"), a photopolymerizable compound (B) (hereinafter a "component (B)"), and a photoradical polymerization initiator (C) (hereinafter also referred to as a "component (C)"), in which the content of the component (C) is 10 parts by mass or more with respect to 100 parts by mass of the total content of the component (X) and the component (B).

### <Component (X)>

The component (X) is a metal oxide nanoparticle.

The term "nanoparticles" means particles having a volume-average primary particle diameter in the nanometer order (less than 1,000 nm). The metal oxide nanoparticles are metal oxide particles having the volume-average primary particle diameter in nanometer order.

The average primary particle diameter of the component (X) is preferably 100 nm or less. The volume-average primary particle diameter of the component (X) is preferably 0.1 to 100 nm, more preferably 1 to 60 nm, still more preferably 1 to 50 nm, even still more preferably 1 to 45 nm, and particularly preferably 1 to 40 nm. The average primary particle diameter of the component (X) is still more preferably 5 to 30 nm, 5 to 25 nm, or 5 to 30 nm. The metal oxide nanoparticles are satisfactorily dispersed in the photocurable composition by setting the volume-average primary particle diameter of the metal nanoparticles of the component (X) to be in the preferred range. In addition, the refractive index is enhanced. The volume-average primary particle diameter is a value measured by a dynamic light scattering method.

Commercially available metal oxide nanoparticles can be used as the component (X). Examples of the metal oxide include oxide particles of titanium (Ti), zirconium (Zr), aluminum (Al), silicon (Si), zinc (Zn), or magnesium (Mg). Among those, the component (X) is preferably a titania (TiO₂) nanoparticle or a zirconia (ZrO₂) nanoparticle from the viewpoint of the refractive index.

In the present embodiment, commercially available metal oxide nanoparticles can be used as the component (X).

Examples of the commercially available titania nanoparticles include TTO series (TTO-51 (A), TTO-51 (C), and the like, and TTO-S, and TTO-V series (TTO-S-1, TTO-S-2, TTO-V-3, and the like) manufactured by Ishihara Sangyo Kaisha, Ltd., TITANIASOL LDB-014-35 manufactured by Ishihara Sangyo Kaisha, Ltd., MT series (MT-01, MT-05, MT-100SA, MT-500SA, and the like) manufactured by TAYCA Corporation, ELECOM V-9108 manufactured by JGC Catalysts and Chemicals Ltd., and STR-100A-LP manufactured by Sakai Chemical Industry Co., Ltd.

Examples of the commercially available zirconia nanoparticles include UEP (manufactured by Daiichi Kigenso Kagaku Kogyo Co., Ltd.), PCS (manufactured by Nippon Denko Co., Ltd.), JS-01, JS-03, and JS-04 (manufactured by Nippon Denko Co., Ltd.), and UEP-100 (manufactured by Daiichi Kigenso Kagaku Kogyo Co., Ltd.).

In the photocurable composition of the present embodiment, the component (X) may be used alone or in combination of two or more kinds thereof.

The content of the component (X) in the photocurable composition of the present embodiment can be set to 10 to 99 parts by mass with respect to a total of 100 parts by mass of the component (X) and the component (B) which will be described later. The content of the component (X) in the photocurable composition of the present embodiment is preferably 60 to 90 parts by mass, more preferably 60 to 85 parts by mass, still more preferably 60 to 80 parts by mass, and particularly preferably 60 to 75 parts by mass with respect to a total of 100 parts by mass of the component (X) and the component (B) which will be described later.

In a case where the content of the component (X) is equal to or more than the lower limit value of the above-described preferred range, the optical characteristics of a cured film formed of the photocurable composition are further enhanced. On the other hand, in a case where the content of the component (X) is equal to or less than the upper limit value of the above-described preferred range, the filling property of the photocurable composition into the mold is improved.

### <Component (B)>

The component (B) is a photopolymerizable compound having a polymerizable functional group.

The term "polymerizable functional group" is a group which is capable of polymerizing compounds through radical polymerization or the like, and refers to a group including multiple bonds between carbon atoms, such as an ethylenic double bond.

Examples of the polymerizable functional group include a vinyl group, an allyl group, acryloyl group, a methacryloyl group, a fluorovinyl group, a difluorovinyl group, a trifluorovinyl group, a difluorotrifluoromethylvinyl group, a trifluoroallyl group, a perfluoroallyl group, a trifluoromethylacryloyl group, a nonylfluorobutylacryloyl group, a vinyl ether group, a fluorine-containing vinyl ether group, an allyl ether group, a fluorine-containing allyl ether group, a styryl group, a vinylnaphthyl group, a fluorine-containing styryl group, a fluorine-containing vinylnaphthyl group, a norbornyl group, a fluorine-containing norbornyl group, and a silyl group. Among these, the vinyl group, the allyl group, the acryloyl group, or the methacryloyl group is preferable, and the acryloyl group or the methacryloyl group is more preferable.

Examples of the photopolymerizable compound (monofunctional monomer) having one polymerizable functional group include a (meth)acrylate including an aliphatic polycyclic structure (hereinafter referred to as a "component (B1)") such as isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, and tricyclodecanyl (meth)acrylate; a (meth)acrylate including an aliphatic monocyclic structure, such as dicyclopentanyl (meth)acrylate, dicyclopentenyl (meth)acrylate, cyclohexyl (meth)acrylate, 4-butylcyclohexyl (meth)acrylate, and acryloyl morpholine; a (meth)acrylate including a chain-like structure, such as 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, and isostearyl (meth)acrylate; a (meth)acrylate including an aromatic ring structure (hereinafter referred to as a "component (B2)") such as benzyl (meth)acrylate, phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, a (meth)acrylate of an EO-modified p-cumylphenol, 2-bromophenoxyethyl (meth)acrylate, 2,4-dibromophenoxyethyl (meth)acrylate, 2,4,6-tribromophenoxyethyl (meth)acrylate, an EO-modified phenoxy (meth)acrylate, a PO-modified phenoxy (meth)acrylate, and polyoxyethylene nonylphenyl ether (meth)acrylate; tetrahydrofurfuryl (meth)acrylate, butoxyethyl (meth)acrylate, ethoxydiethylene glycol (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, and methoxypolypropylene glycol (meth)acrylate; diacetone (meth)acryl amide, isobutoxymethyl (meth)acryl amide, N,N-dimethyl (meth)acryl amide, t-octyl (meth)acryl amide, dimethylaminoethyl (meth)acrylate, diethylaminoethyl (meth)acrylate, 7-amino-3,7-dimethyloctyl (meth)acrylate, N,N-diethyl (meth)acryl amide, and N,N-dimethylaminopropyl (meth)acryl amide; and one-terminal methacrylic siloxane monomer.

Examples of the commercially available product of the monofunctional monomer include ARONIX M101, M102, M110, M111, M113, M117, M5700, TO-1317, M120, M150, and M156 (all manufactured by Toagosei Co., Ltd.); MEDOL 10, MIBDOL 10, CHDOL 10, MMDOL 30, MEDOL 30, MIBDOL 30, CHDOL 30, LA, IBXA, 2-MTA, HPA, VISCOAT # 150, # 155, # 158, # 190, # 192, # 193, # 220, # 2000, # 2100, and # 2150 (all manufactured by Osaka Organic Chemical Industry Co., Ltd.); LIGHT ACRYLATE BO-A, EC-A, DMP-A, THF-A, HOP-A, HOA-MPE, HOA-MPL, HOA (N), PO-A, P-200A, NP-4EA, NP-8EA, IB-XA, and EPOXY ESTER M-600A (all manufactured by Kyoeisha Chemical Co., Ltd.); KAYARAD TC110S, R-564, and R-128H (all manufactured by Nippon Kayaku Co., Ltd.); NK ESTER AMP-10G and AMP-20G (all manufactured by SHIN-NAKAMURA CHEMICAL Co, Ltd.); FA-511A, FA-512A, FA-513A, and FA-BZA (all manufactured by Showa Denko Materials Co., Ltd.); PHE, CEA, PHE-2, PHE-4, BR-31, BR-31M, and BR-32 (all manufactured by DKS Co., Ltd.); VP (manufactured by BASF SE); ACMO, DMAA, and DMAPAA (all manufactured by Kohjin co., Ltd.); and X-22-2404 (manufactured by Shin-Etsu Chemical Industry Co., Ltd.).

Examples of the photopolymerizable compound having two polymerizable functional groups (bifunctional monomer) include trimethylolpropane di(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth)acrylate, 1,6-hexanediol di(meth)acrylate, neopentyl glycol di(meth)acrylate, and bis(hydroxymethyl) tricyclodecane di(meth)acrylate.

Examples of the commercially available product of the bifunctional monomer include LIGHT ACRYLATE 3EG-A, 4EG-A, 9EG-A, NP-A, DCP-A, BP-4EAL, and BP-4PA (all manufactured by Kyoeisha Chemical Co., Ltd.).

Examples of the photopolymerizable compound having three or more polymerizable functional groups include a photopolymerizable siloxane compound, a photopolymerizable silsesquioxane compound, and a polyfunctional monomer having three or more polymerizable functional groups.

Examples of the photopolymerizable siloxane compound include a compound having an alkoxysilyl group and a polymerizable functional group in the molecule.

Examples of the commercially available product of the photopolymerizable siloxane compound include product names "KR-513", "X-40-9296", "KR-511 ", "X-12-1048", and "X-12-1050", all manufactured by Shin-Etsu Chemical Co., Ltd.

Examples of the photopolymerizable silsesquioxane compound include a compound which has a main chain skeleton composed of a Si-O bond and is represented by the following chemical formula: [(RSiO_{3/2})ₙ] (in the formula, R represents an organic group and n represents a natural number).

R represents a monovalent organic group, and examples of the monovalent organic group include a monovalent hydrocarbon group which may have a substituent. Examples of this hydrocarbon group include an aliphatic hydrocarbon group and an aromatic hydrocarbon group. Examples of the aliphatic hydrocarbon group include alkyl groups having 1 to 12 carbon atoms such as a methyl group, an ethyl group, an n-propyl group, an isopropyl group, an n-butyl group, a sec-butyl group, a tert-butyl group, a pentyl group, a hexyl group, a heptyl group, a 2-ethylhexyl group, an octyl group, a nonyl group, a decyl group, an undecyl group, and a dodecyl group, where an alkyl group having 1 to 20 carbon atoms is preferable.

Examples of the aromatic hydrocarbon group include aromatic hydrocarbon groups having 6 to 20 carbon atoms such as a phenyl group, a naphthyl group, a benzyl group, a tolyl group, and a styryl group.

Examples of the substituent which may be contained in the monovalent hydrocarbon group include a (meth)acryloyl group, a hydroxy group, a sulfanyl group, a carboxy group, an isocyanato group, an amino group, and a ureido group. In addition, - CH₂- contained in the monovalent hydrocarbon group may be replaced with -O-, -S-, a carbonyl group, or the like.

However, the photopolymerizable silsesquioxane compound has three or more polymerizable functional groups. Examples of the polymerizable functional group here include a vinyl group, an allyl group, a methacryloyl group, and an acryloyl group.

The compound represented by Chemical Formula: [(RSiO_{3/2})ₙ] may be of a basket type, a ladder type, or a random type. The cage-type silsesquioxane compound may be a complete cage type or may be an incomplete cage type such as one in which a part of the cage is open.

Examples of commercially available products of the photopolymerizable silsesquioxane compound include product names "MAC-SQ LP-35", "MAC-SQ TM-100", "MAC-SQ SI-20", and "MAC-SQ HDM", all manufactured by Toagosei Co., Ltd.

Examples of the polyfunctional monomer having three or more polymerizable functional groups include trifunctional monomers such as ethoxylated (3) trimethylolpropane triacrylate, ethoxylated (3) trimethylolpropane trimethacrylate, ethoxylated (6) trimethylolpropane triacrylate, ethoxylated (9) trimethylolpropane triacrylate, ethoxylated (15) trimethylolpropane triacrylate, ethoxylated (20) trimethylolpropane triacrylate, pentaerythritol triacrylate, pentaerythritol trimethacrylate, propoxylated (3) glyceryl triacrylate, propoxylated (3) glyceryl triacrylate, propoxylated (5.5) glyceryl triacrylate, propoxylated (3) trimethylolpropane triacrylate, propoxylated (6) trimethylolpropane triacrylate, trimethylolpropane triacrylate, trimethylolpropane trimethacrylate, tris-(2-hydroxyethyl)-isocyanurate triacrylate, tris-(2-hydroxyethyl)-isocyanurate trimethacrylate, ε-caprolactone-modified tris-(2-acryloxyethyl)isocyanurate, EO-modified trimethylolpropane tri(meth)acrylate, PO-modified trimethylolpropane tri(meth)acrylate, and EO- and PO-modified trimethylolpropane tri(meth)acrylate; tetrafunctional monomers such as ditrimethylolpropane tetraacrylate, ethoxylated (4) pentaerythritol tetraacrylate, and pentaerythritol tetra(meth)acrylate; and pentafunctional or higher functional monomers such as dipentaerythritol pentaacrylate and dipentaerythritol hexaacrylate.

Examples of the commercially available products of the polyfunctional monomer include product names "A-9300-1CL", "AD-TMP", "A-9550", and "A-DPH", all manufactured by Shin-Nakamura Chemical Co., Ltd., product name "KAYARAD DPHA", manufactured by Nippon Kayaku Co., Ltd., and product name "Light Acrylate TMP-A" manufactured by Kyoeisha Chemical Co., Ltd.

The component (B) may be a photopolymerizable sulfur compound (hereinafter also referred to as a component (BS)). The "photopolymerizable sulfur compound" is a photopolymerizable compound having a sulfur atom in the molecule. That is, the photopolymerizable sulfur compound is a monomer having a sulfur atom and a polymerizable functional group.

Examples of the component (BS) include a compound having a diaryl sulfide skeleton. Examples of the compound having a diaryl sulfide skeleton include a compound represented by General Formula (bs-1).

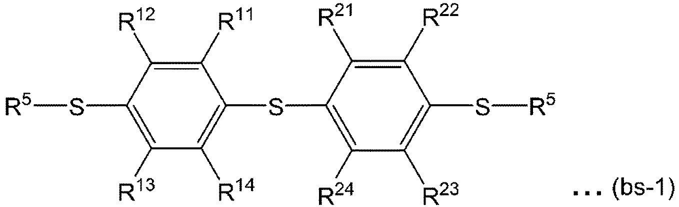

[In the formula, R¹¹ to R¹⁴ and R²¹ to R²⁴ each independently represents a hydrogen atom, an alkyl group, or a halogen atom, and R⁵ represents a polymerizable functional group.]

In Formula (bs-1), R¹¹ to R¹⁴ and R²¹ to R²⁴ each independently represents a hydrogen atom, an alkyl group, or a halogen atom.

The number of carbon atoms in the alkyl group is preferably 1 to 10, more preferably 1 to 6, still more preferably 1 to 4, and particularly preferably 1 to 3.

The alkyl group may be linear, branched, or cyclic. It is preferable that the alkyl group be linear or branched.

Examples of the linear alkyl group include a methyl group, an ethyl group, an n-propyl group, and an n-butyl group.

Examples of the branched alkyl group include an isopropyl group, a sec-butyl group, and a tert-butyl group.

Among those, as the alkyl group, the methyl group or the ethyl group is preferable, and the methyl group is more preferable.

Examples of the halogen atom as R¹¹ to R¹⁴ and R²¹ to R²⁴ include a fluorine atom, a chlorine atom, a bromine atom, and an iodine atom. Among these, the chlorine atom is particularly preferable as the halogen atom.

R¹¹ to R¹⁴ and R²¹ to R²⁴ are each preferably the hydrogen atom or the alkyl group, more preferably the hydrogen atom, a methyl group, or the ethyl group, and still more preferably the hydrogen atom.

In Formula (bs-1), R⁵ represents a polymerizable functional group.

Examples of the polymerizable functional group include the same groups as those exemplified above. Among those, the vinyl group, the allyl group, the acryloyl group, or the methacryloyl group is preferable, and the acryloyl group or the methacryloyl group is more preferable as the polymerizable group.

R⁵ is preferably the acryloyl group or the methacryloyl group, and more preferably the acryloyl group or the methacryloyl group.

Examples of the component (BS) include bis(4-methacryloylthiophenyl) sulfide and bis(4-acryloylthiophenyl) sulfide. Among these, bis(4-methacryloylthiophenyl) sulfide is preferable as the component (BS).

In the photocurable composition of the present embodiment, the component (B) may be used alone or in combination of two or more kinds thereof.

It is preferable that the component (B) include the component (B) other than the component (BS) (hereinafter also referred to as the component (B1)), and it is more preferable that the component (B1) and the component (BS) be used in combination. In a case where the component (B1) and the component (BS) are used in combination, the refractive index of a cured film formed of the photocurable composition is further improved.

The content of the component (B) can be set to 5 to 80 parts by mass with respect to a total of 100 parts by mass of the component (X) and the component (B). The content of the component (B) is preferably 10 to 40 parts by mass, more preferably 15 to 40 parts by mass, still more preferably 20 to 40 parts by mass, and particularly preferably 25 to 40 parts by mass with respect to a total of 100 parts by mass of the component (X) and the component (B).

In a case where the content of the component (B) is equal to or more than the lower limit value of the preferred range, the curability and the fluidity of a resin cured film formed of the photocurable composition are improved. On the other hand, in a case where the content of the component (B) is equal to or less than the upper limit value of the preferred range, the dispersibility of the component (X) in the photocurable composition is enhanced.

In a case where the component (B1) and the component (BS) are used in combination, the mass ratio of the component (B1) to the component (BS) can be set to, for example, a mass ratio such that the component (B1):the component (B2) = 1:10 to 10:1. As the mass ratio of the component (B1) to the component (BS), the component (B1):the component (B2) is preferably 1:5 to 5:1, more preferably 1:3: to 3:1, and still more preferably 1:2 to 2:1.

In a case where the mass ratio of the component (B1) to the component (BS) is within the preferred range, the refractive index and the haze of a cured film formed of the photocurable composition are further enhanced.

### <Component (C)>

The component (C) is a photoradical polymerization initiator.

As the component (C), a compound that initiates the polymerization of the component (B) or accelerates the polymerization upon exposure is used.

Examples of the component (C) include 1-hydroxycyclohexylphenyl ketone, 2-hydroxy-2-methyl-1-phenylpropan-1-one, 1-[4-(2-hydroxyethoxy)phenyl]-2-hydroxy-2-methyl-1-propan-1-one, 1-(4-isopropylphenyl)-2-hydroxy-2-methylpropan-1-one, 1-(4-dodecylphenyl)-2-hydroxy-2-methylpropan-1-one, 2,2-dimethoxy-1,2-diphenylethan-1-one, bis(4-dimethylaminophenyl) ketone, 2-methyl-1-(4-methylthiophenyl)-2-morpholinopropan-1-one, 2-benzyl-2-dimethylamino-1-(4-morpholinophenyl)-butanone-1, ethanone-1-[9-ethyl-6-(2-methylbenzoyl)-9H-carbazol-3-yl]-1-(o-acetyloxime), bis(2,4,6-trimethylbenzoyl)-phenylphosphine oxide, 4-benzoyl-4'-methyldimethyl sulfide, 4-dimethylaminobenzoic acid, methyl 4-dimethylaminobenzoate, ethyl 4-dimethylaminobenzoate, butyl 4-dimethylaminobenzoate, 4-dimethylamino-2-ethylhexyl benzoate, 4-dimethylamino-2-isoamylbenzoate, benzyl-β-methoxyethyl acetal, benzyl dimethyl ketal, 1-phenyl-1,2-propanedione-2-(o-ethoxycarbonyl)oxime, methyl o-benzoylbenzoate, 2,4-diethylthioxanthone, 2-chlorothioxanthone, 2,4-dimethylthioxanthone, 1-chloro-4-propoxythioxanthone, thioxanthene, 2-chlorothioxanthene, 2,4-diethylthioxanthene, 2-methylthioxanthene, 2-isopropylthioxanthene, 2-ethylanthraquinone, octamethyl anthraquinone, 1,2-benzanthraquinone, 2,3-diphenylanthraquinone, azobis isobutyronitrile, benzoyl peroxide, cumene peroxide, 2-mercaptobenzoimidazole, 2-mercaptobenzoxazole, 2-mercaptobenzothiazole, a 2-(o-chlorophenyl)-4,5-di(m-methoxyphenyl)-imidazolyl dimer, benzophenone, 2-chlorobenzophenone, p,p'-bisdimethylaminobenzophenone, 4,4'-bisdiethylaminobenzophenone, 4,4'-dichlorobenzophenone, 3,3-dimethyl-4-methoxybenzophenone, benzoyl, benzoin, benzoin methyl ether, benzoin ethyl ether, benzoin isopropyl ether, benzoin-n-butyl ether, benzoin isobutyl ether, benzoin butyl ether, acetophenone, 2,2-diethoxyacetophenone, p-dimethyl acetophenone, p-dimethylaminopropiophenone, dichloroacetophenone, trichloroacetophenone, p-tert-butylacetophenone, p-dimethylaminoacetophenone, p-tert-butyltrichloroacetophenone, p-tert-butyldichloroacetophenone, α,α-dichloro-4-phenoxyacetophenone, 2,2-dimethoxy-2-phenylacetophenone, thioxanthone, 2-methylthioxanthone, 2-isopropylthioxanthone, dibenzosuberone, pentyl-4-dimethylaminobenzoate, 9-phenylacridine, 1,7-bis-(9-acridinyl)heptane, 1,5-bis-(9-acridinyl)pentane, 1,3-bis-(9-acridinyl)propane, p-methoxytriazine, 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(furan-2-yl)ethenyl]-4,6-bis(trichloromethyl)-s-triazine, 2-[2-(4-diethylamino-2-methylphenyl)ethenyl]-4,6-bis(trichloromethyl)-s-triazine, 2-[2-(3,4-dimethoxyphenyl)ethenyl]-4,6-bis(trichloromethyl)-s-triazine, 2-(4-methoxyphenyl)-4,6-bis(trichloromethyl)-s-triazine, 2-(4-ethoxystyryl)-4,6-bis(trichloromethyl)-s-triazine, 2-(4-n-butoxyphenyl)-4,6-bis(trichloromethyl)-s-triazine, 2,4-bis-trichloromethyl-6-(3-bromo-4-methoxy)phenyl-s-triazine, 2,4-bistrichloromethyl-6-(2-bromo-4-methoxy)phenyl-s-triazine, 2,4-bis-trichloromethyl-6-(3-bromo-4-methoxy)styrylphenyl-s-triazine, 2,4-bis-trichloromethyl-6-(2-bromo-4-methoxy)styrylphenyl-s-triazine; ketone peroxides such as methyl ethyl ketone peroxide, methyl isobutyl ketone peroxide, cyclohexanone peroxide; diacyl peroxides such as isobutyryl peroxide and bis(3,5,5-trimethylhexanoyl)peroxide; hydroperoxides such as p-menthane hydroperoxide and 1,1,3,3-tetramethylbutylhydroperoxide; dialkyl peroxides such as 2,5-dimethyl-2,5-bis(t-butylperoxy)hexane; peroxyketals such as 1,1-bis(t-butylperoxy)-3,3,5-trimethylcyclohexane; peroxyesters such as t-butylperoxyneodecanoate and 1,1,3,3-tetramethylperoxyneodecanoate; peroxydicarbonates such as di-n-propylperoxydicarbonate and diisopropylperoxydicarbonate; and azo compounds such as azobis isobutyronitrile, 2,2'-azobis(2,4-dimethylvaleronitrile) and 2,2'-azobisisobutyrate.

Among those, 1-hydroxycyclohexylphenyl ketone, 2-methyl-1-(4-methylthiophenyl)-2-morpholinopropan-1-one, 2-benzyl-2-dimethylamino-1-(4-morpholinophenyl)-butanon-1, bis(2,4,6-trimethylbenzoyl)-phenylphosphine oxide, and 2,2-dimethoxy-2-phenylacetophenone are preferable.

As the component (C), a commercially available product can be obtained and used.

Examples of the commercially available product of the component (C) include product name "IRGACURE 907" manufactured by BASF SE, product name "IRGACURE 369" manufactured by BASF SE, product name "IRGACURE 819" manufactured by BASF SE, and product names "Omnirad 184", "Omnirad 651", "Omnirad 819", and "Omnirad 184", all manufactured by IGM Resins B. V.

It is preferable that the component (C) have a low molecular weight. In a case where the molecular weight of the component (C) is low, the haze tends to further decrease. The molecular weight of the component (C) is, for example, preferably 500 or less, more preferably 400 or less, still more preferably 350 or less, and particularly preferably 300 or less. The lower limit value of the molecular weight of the component (C) is not particularly limited and may be 100 or more, 150 or more, or 200 or more. The molecular weight of the component (C) can be, for example, set to 100 to 500 and is preferably 150 to 500, more preferably 150 to 400, still more preferably 150 to 350, and particularly preferably 150 to 300.

In the photocurable composition of the present embodiment, the component (C) may be used alone or in combination of two or more kinds thereof.

In the photocurable composition of the present embodiment, the content of the component (C) is 10 parts by mass or more with respect to 100 parts by mass of the total content of the component (X) and the component (B). As shown in Examples described later, it is possible to maintain 0.4% or less of the haze value of a cured film formed using the photocurable composition of the present embodiment by setting the content of the component (C) to equal to or more than the lower limit value.

Devices such as 3D sensors and AR glasses are required to have both a high refractive index and a high transparency. However, in a case where a high refractive index is achieved, the haze in the visible light region is deteriorated, and the transparency is deteriorated. Therefore, in the photocurable composition in the related art, it has been difficult to achieve both a high refractive index and reduced haze. In the photocurable composition of the present embodiment, it is possible to reduce haze while maintaining a high refractive index by setting the content of the component (C) to equal to or more than the lower limit value.

The content of the component (C) is preferably 15 parts by mass or more, more preferably 20 parts by mass or more, and still more preferably 25 parts by mass or more with respect to 100 parts by mass of the total content of the component (X) and the component (B). The upper limit value of the content of the component (C) is not particularly limited, but is, for example, preferably 50 parts by mass or less, more preferably 45 parts by mass or less, still more preferably 40 parts by mass or less, and particularly preferably 30 parts by mass or less with respect to 100 parts by mass of the total content of the component (X) and the component (B). By setting the content of the component (C) to be equal to or less than the upper limit value, the refractive index can be satisfactorily maintained. The content of the component (C) is preferably 1 to 50 parts by mass, more preferably 15 to 45 parts by mass, still more preferably 20 to 40 parts by mass, and particularly preferably 20 to 30 parts by mass with respect to 100 parts by mass of the total content of the component (X) and the component (B).

### <Optional Components>

The photocurable composition of the present embodiment may contain other components in addition to the component (X), the component (B), and the component (C). Examples of the optional component include a solvent (hereinafter also referred to as a "component (S)") and a miscible additive (for example, a deterioration inhibitor, a release agent, a diluent, an antioxidant, a thermal stabilizer, a flame retardant, a plasticizer, and a surfactant, as well as another additive for improving the characteristics of the cured film).

### <<Solvent: Component (S)>>

The photocurable composition of the present embodiment may contain a solvent (component (S)). The component (S) is used to dissolve or disperse, and mix the component (X), the component (B), and the component (C), and desired optional components.

Specific examples of the component (S) include alcohols having a chain structure, such as methanol, ethanol, n-propyl alcohol, isopropyl alcohol, n-pentyl alcohol, s-pentyl alcohol, t-pentyl alcohol, isopentyl alcohol, 2-methyl-1-propanol, 2-ethyl butanol, neopentyl alcohol, n-butanol, s-butanol, t-butanol, 1-propanol, n-hexanol, 2-heptanol, 3-heptanol, 2-methyl-1-butanol, 2-methyl-2-butanol, 4-methyl-2-pentanol, 1-butoxy-2-propanol, propylene glycol monopropyl ether, 5-methyl-1-hexanol, 6-methyl-2-heptanol, 1-octanol, 2-octanol, 3-octanol, 4-octanol, 2-ethyl-1-hexanol, and 2-(2-butoxyethoxy) ethanol; alcohols having a cyclic structure, such as cyclopentanemethanol, 1-cyclopentylethanol, cyclohexanol, cyclohexanemethanol, cyclohexaneethanol, 1,2,3,6-tetrahydrobenzyl alcohol, exo-norborneol, 2-methylcyclohexanol, cycloheptanol, 3,5-dimethylcyclohexanol, benzyl alcohol, and terpineol; and derivatives of polyhydric alcohols, such as compounds having an ester bond, such as ethylene glycol monoacetate, diethylene glycol monoacetate, propylene glycol monoacetate, and dipropylene glycol monoacetate, and compounds having an ether bond, such as monoalkyl ether such as monomethyl ether, monoethyl ether, monopropyl ether, or monobutyl ether or monophenyl ether of the polyhydric alcohols or the compounds having an ester bond [among these, propylene glycol monomethyl ether acetate (PGMEA) and propylene glycol monomethyl ether (PGME) are preferable].

In the photocurable composition of the present embodiment, the component (S) may be used alone or in combination of two or more kinds thereof.

Among these, as the component (S), at least one selected from the group consisting of propylene glycol monomethyl ether acetate (PGMEA) and propylene glycol monomethyl ether (PGME) is preferable.

The amount of the component (S) to be used is not particularly limited and may be appropriately set according to the thickness of the coating film of the photocurable composition. The component (S) in the photocurable composition can be used, for example, such that the content thereof is about 100 to 500 parts by mass with respect to 100 parts by mass of the total content of the component (X) and the component (B).

### <<Surfactant: Component (E)>>

The photocurable composition of the present embodiment may contain a surfactant in order to adjust the coatability and the like.

Examples of the surfactant include a silicone-based surfactant and a fluorine-based surfactant. As the silicone-based surfactant, it is possible to use, for example, BYK-077, BYK-085, BYK-300, BYK-301, BYK-302, BYK-306, BYK-307, BYK-310, BYK-320, BYK-322, BYK-323, BYK-325, BYK-330, BYK-331, BYK-333, BYK-335, BYK-341, BYK-344, BYK-345, BYK-346, BYK-348, BYK-354, BYK-355, BYK-356, BYK-358, BYK-361, BYK-370, BYK-371, BYK-375, BYK-380, and BYK-390 (all manufactured by BYK Chemie). As the fluorine-based surfactant, F-114, F-177, F-410, F-411, F-450, F-493, F-494, F-443, F-444, F-445, F-446, F-470, F-471, F-472SF, F-474, F-475, F-477, F-478, F-479, F-480SF, F-482, F-483, F-484, F-486, F-487, F-172D, MCF-350SF, TF-1025SF, TF-1117SF, TF-1026SF, TF-1128, TF-1127, TF-1129, TF-1126, TF-1130, TF-1116SF, TF-1131, TF-1132, TF-1027SF, TF-1441, and TF-1442 (all manufactured by DIC Corporation); or PolyFox Series PF-636, PF-6320, PF-656, and PF-6520 (all manufactured by OMNOVA Solutions Inc.), or the like can be used.

In the photocurable composition of the present embodiment, the surfactants may be used alone or in combination of two or more kinds thereof.

In a case where the photocurable composition of the present embodiment contains a surfactant, the content of the surfactant is preferably 0.01 to 3 parts by mass, more preferably 0.02 to 1 part by mass, and still more preferably 0.03 to 0.5 parts by mass with respect to 100 parts by mass of the total content of the component (X) and the component (B).

In a case where the content of the surfactant is in the above-described preferred range, the coatability of the photocurable composition is enhanced.

The cured film formed of the photocurable composition of the present embodiment usually has a refractive index of 1.70 or more at a wavelength of 530 nm. Since the photocurable composition of the present embodiment can form a cured film having such a high refractive index, it can be suitably used for applications requiring a high refractive index, such as a 3D sensor and an augmented reality (AR) waveguide for AR glasses. The refractive index of the cured film can be measured by a spectroscopic ellipsometer.

The cured film having a film thickness of 600 nm, which is formed by using the photocurable composition of the present embodiment, typically has a haze value of 0.4% or less as measured in accordance with ASTM D100. Since the photocurable composition of the present embodiment can form a cured film having such a low haze value, the composition can be suitably used for applications requiring high transparency, such as 3D sensors and augmented reality (AR) waveguides for AR glasses. The haze value of the cured film can be measured by a haze meter in accordance with ASTM D100.

The photocurable composition of the present embodiment described above contains the component (X), the component (B), and the component (C), in which the content of the component (C) is 10 parts by mass or more with respect to 100 parts by mass of the total content of the component (X) and the component (B). In the photocurable composition of the present embodiment, it is possible to reduce haze while realizing a high refractive index of a cured film by setting the content of the component (C) to equal to or more than the predetermined value. The reason why the photocurable composition of the present embodiment exhibits the effects as described above is not clear, but the following reasons can be considered.

In the cured film of the photocurable composition including the component (X), it is considered that light scattering occurs at an interface between the component (X) and the polymer of the component (B) present in the vicinity thereof, and haze in the visible light region is deteriorated. In the photocurable composition of the present embodiment, light is absorbed by the component (C) before the light reaches the interface between the component (X) and the polymer of the component (B) by setting the content of the component (C) to 10 parts by mass or more with respect to 100 parts by mass of the total content of the component (X) and the component (B). This is presumed to suppress the scattering of light at the interface between the component (X) and the polymer of the component (B) and the secondary and tertiary scattering generated through an interfacial reflection phenomenon, thereby reducing the haze. Furthermore, it is considered that the crosslinking density of the component (B) is improved by setting the content of the component (C) to equal to or more than the predetermined value. This is presumed to reduce a difference in refractive index at the interface between the component (X) and the polymer of the component (B) and suppress the scattering of light, thereby reducing the haze.

Such a photocurable composition is useful as a material for forming a fine pattern on a substrate according to imprint technology, and is particularly suitable for optical imprint lithography. In particular, the photocurable composition exerts an advantageous effect in applications that require low haze and a high refractive index, such as 3D sensors for autonomous driving and augmented reality (AR) waveguides for AR glasses.

In addition, the photocurable composition of the present embodiment is also useful as a material for an antireflection film or the like.

### (Pattern-forming Method)

A pattern-forming method of a second aspect of the present invention includes a step of forming a photocurable film on a substrate using the photocurable composition of the first aspect (hereinafter referred to as a "step (i)"), a step of pressing a mold having an uneven pattern against the photocurable film to transfer the uneven pattern to the photocurable film (hereinafter also referred to as a "step (ii)"), a step of exposing the photocurable film to which the uneven pattern has been transferred while pressing the mold against the photocurable film to form a cured film (hereinafter also referred to as a "step (iii)"), and a step of peeling off the mold from the cured film (hereinafter also referred to as a "step (iv)").

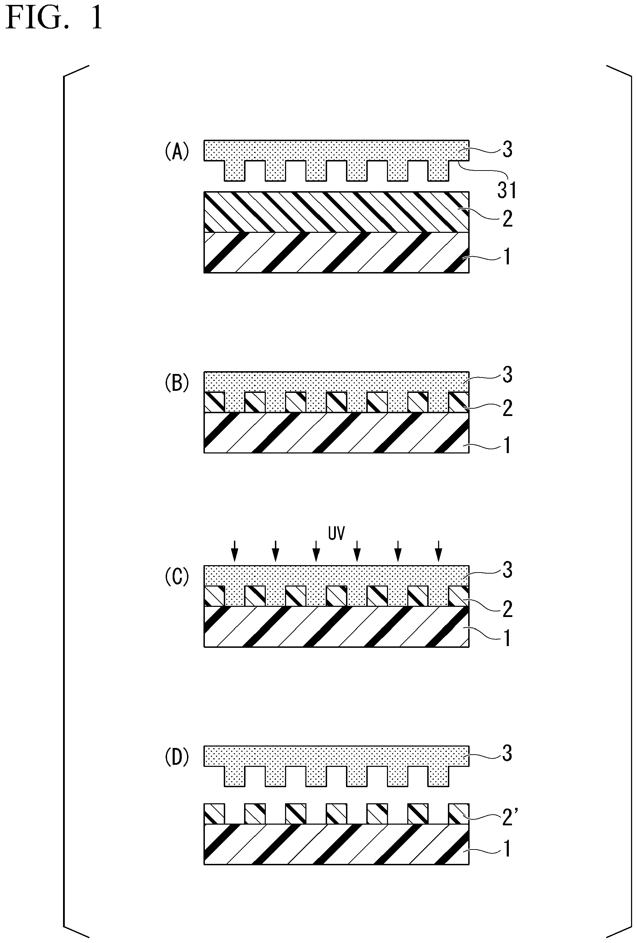

FIG. 1 is a schematic process chart describing an embodiment of the pattern-forming method.

### [Step (i)]

In the step (i), a photocurable film is formed on a substrate using the above-mentioned photocurable composition of the first aspect.

As shown in FIG. 1(A), the above-mentioned photocurable composition of the first aspect is applied onto a substrate 1 to form a photocurable film 2. Furthermore, in FIG. 1(A), a mold 3 is disposed above the photocurable film 2.

The substrate 1 can be selected depending on various applications, and examples thereof include a substrate for an electronic component and a substrate on which a predetermined wiring pattern is formed. Specific examples thereof include a substrate made of a metal such as silicon, silicon nitride, copper, chromium, iron, aluminum, or the like; and a glass substrate. Examples of the material for the wiring pattern include copper, aluminum, nickel, and gold.

The shape of the substrate 1 is not particularly limited and may be a plate shape or a roll shape. As the substrate 1, a light-transmitting or non-light-transmitting substrate can be selected depending on a combination with the mold and the like.

Examples of the method for applying the photocurable composition onto the substrate 1 include a spin coating method, a spray method, an inkjet method, a roll coating method, and a rotary coating method. Since the photocurable film 2 functions as a mask of the substrate 1 in an etching step which may be subsequently performed, it is preferable that the photocurable film 2 have a uniform film thickness in a case of being applied onto the substrate 1. From this viewpoint, the spin coating method is suitable in a case where the photocurable composition is applied onto the substrate 1.

The film thickness of the photocurable film 2 may be appropriately selected depending on applications thereof, and may be, for example, approximately 0.05 to 30 µm.

### [Step (ii)]

In the step (ii), a mold having an uneven pattern is pressed against the photocurable film to transfer the uneven pattern to the photocurable film.

As shown in FIG. 1(B), the mold 3 having a fine uneven pattern on a surface thereof is pressed against the substrate 1 on which the photocurable film 2 has been formed such that the mold 3 faces the photocurable film 2. This enables the photocurable film 2 to be deformed according to the uneven structure of the mold 3.

The pressure on the photocurable film 2 during the pressing of the mold 3 is preferably 10 MPa or less, more preferably 5 MPa or less, and particularly preferably 1 MPa or less.

By pressing the mold 3 against the photocurable film 2, the photocurable composition positioned at projection portions of the mold 3 is easily pushed away to the side of recessed portions of the mold 3, and thus, the uneven structure of the mold 3 is transferred to the photocurable film 2.

The uneven pattern of the mold 3 can be formed according to a desired processing accuracy by, for example, photolithography and an electron beam drawing method.

A light-transmitting mold is preferable as the mold 3. A material for the light-transmitting mold is not particularly limited, but may be any material having predetermined strength and durability. Specific examples thereof include light-transparent resin films such as glass, quartz, polymethyl methacrylate, and a polycarbonate resin, transparent metal vapor deposition films, flexible films such as polydimethylsiloxane, photocured films, and metal films.

### [Step (iii)]

In the step (iii), the photocurable film to which the uneven pattern has been transferred is exposed while the mold is pressed against the photocurable film to form a resin cured film.

As shown in FIG. 1(C), the photocurable film 2 to which the uneven pattern has been transferred is exposed in a state where the mold 3 is pressed against the photocurable film 2. Specifically, the photocurable film 2 is irradiated with electromagnetic waves such as ultraviolet rays (UV). The photocurable film 2 is cured by exposure in a state where the mold 3 is pressed, and thus a cured film (cured pattern) to which the uneven pattern of the mold 3 has been transferred is formed.

The mold 3 in FIG. 1(C) has transparency to electromagnetic waves.

The light used to cure the photocurable film 2 is not particularly limited and examples thereof include light or radiation having a wavelength in the regions of high-energy ionizing radiation, near ultraviolet rays, far ultraviolet rays, visible rays, infrared rays, and the like. As the radiation, for example, laser light used in fine processing of semiconductors, such as a microwave, EUV, LED, semiconductor laser light, KrF excimer laser light having a wavelength of 248 nm, or ArF excimer laser having a wavelength of 193 nm can also be suitably used. As the light, monochrome light may be used, or light having a plurality of different wavelengths (mixed light) may be used.

### [Step (iv)]

In the step (iv), the mold is peeled off from the cured film.

As shown in FIG. 1(D), the mold 3 is peeled off from the cured film. In this manner, a pattern 2' (cured pattern) composed of the cured film to which the uneven pattern has been transferred is patterned on the substrate 1.

In the pattern-forming method of the present embodiment described above, a photocurable composition containing the component (X), a component (T), the component (B), and the component (C) is used. Since such a photocurable composition is used, a pattern having a high refractive index and excellent light resistance can be formed.

In the present embodiment, a release agent may be applied onto a surface 31 of the mold 3 which is brought into contact with the photocurable film 2 (FIG. 1 (A)). This enables the releasability of the mold from the cured film to be improved.

Examples of the release agent here include a silicone-based release agent, a fluorine-based release agent, a polyethylene-based release agent, a polypropylene-based release agent, a paraffin-based release agent, a montan-based release agent, and a carnauba-based release agent. Among these, the fluorine-based release agent is preferable. For example, a commercially available coating type release agent such as OPTOOL DSX manufactured by Daikin Industries, Ltd. can be suitably used. The release agent may be used alone or in combination of two or more kinds thereof.

In addition, in the present embodiment, an organic substance layer may be provided between the substrate 1 and the photocurable film 2. This enables a desired pattern to be easily and reliably formed on the substrate 1 by etching the substrate 1 using the photocurable film 2 and the organic substance layer as a mask. The film thickness of the organic substance layer may be appropriately adjusted according to the depth at which the substrate 1 is processed (etched), and is preferably 0.02 to 2.0 µm. As a material for the organic substance layer, a material which has lower etching resistance to an oxygen-based gas than that of the photocurable composition and has higher etching resistance to a halogen-based gas than that of the substrate 1 is preferable. The method for forming the organic substance layer is not particularly limited and examples thereof include a sputtering method and a spin coating method.

The pattern-forming method of the second aspect may further include other steps (optional steps) in addition to the steps (i) to (iv).

Examples of the optional steps include an etching step (step (v)) and a cured film (cured pattern)-removing step (step (vi)) after the etching treatment.

### [Step (v)]

In the step (v), the substrate 1 is etched, for example, using the pattern 2' obtained in the above-mentioned steps (i) to (iv) as a mask.

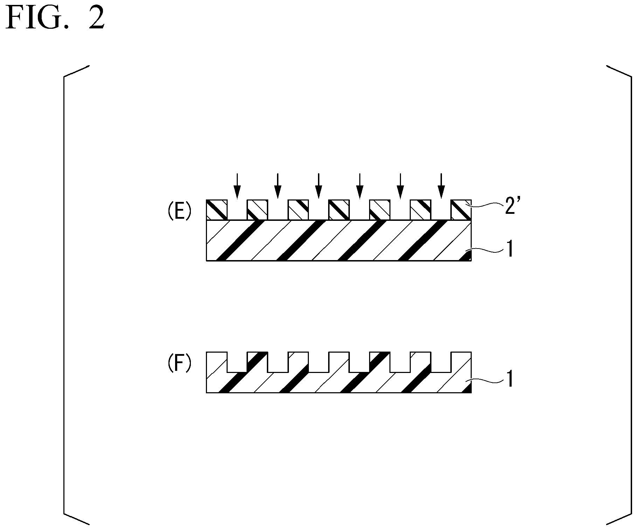

As shown in FIG. 2(E), the substrate 1 on which the pattern 2' has been formed is irradiated with at least one of plasma and reactive ion gas (indicated by arrows) so that the portion of the substrate 1 exposed to the side of the pattern 2' is removed by etching to a predetermined depth.

The plasma or reactive ion gas used in the step (v) is not particularly limited as long as the gas is typically used in the dry etching field.

### [Step (vi)]

In the step (vi), the cured film remaining after the etching treatment in the step (v) is removed.

As shown in FIG. 2(F), the step (vi) is a step of removing the cured film (pattern 2') remaining on the substrate 1 after the etching treatment performed on the substrate 1.

The method for removing the cured film (pattern 2') remaining on the substrate 1 is not particularly limited and examples thereof include a treatment of washing the substrate 1 with a solution in which the cured film is dissolved.

### [Examples]

Hereinafter, the present invention will be described in more detail with reference to Examples, but the present invention is not limited thereto.

### <Preparation of Photocurable Composition>

A photocurable composition of each of the Examples and Comparative Examples was prepared by blending each component listed in Tables 1 to 6.

**[Table 1]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Example 1 | (X)-1 [72] | (B1)-2 [14] | (BS)-1 [14] | (C)-1 [10] | (E)-1 [0.05] | (S)-2 [245] |
| Example 2 | (X)-1 [72] | (B1)-2 [14] | (BS)-1 [14] | (C)-1 [15] | (E)-1 [0.05] | (S)-2 [245] |
| Example 3 | (X)-1 [72] | (B1)-2 [14] | (BS)-1 [14] | (C)-1 [20] | (E)-1 [0.05] | (S)-2 [245] |
| Example 4 | (X)-1 [72] | (B1)-2 [14] | (BS)-1 [14] | (C)-1 [30] | (E)-1 [0.05] | (S)-2 [245] |
| Example 5 | (X)-1 [72] | (B1)-2 [14] | (BS)-1 [14] | (C)-1 [50] | (E)-1 [0.05] | (S)-2 [245] |
| Example 6 | (X)-1 [70] | (B1)-2 [16] | (BS)-1 [14] | (C)-1 [15] | (E)-1 [0.05] | (S)-2 [245] |
| Example 7 | (X)-1 [70] | (B1)-2 [16] | (BS)-1 [14] | (C)-1 [20] | (E)-1 [0.05] | (S)-2 [245] |
| Example 8 | (X)-1 [70] | (B1)-2 [16] | (BS)-1 [14] | (C)-1 [30] | (E)-1 [0.05] | (S)-2 [245] |
| Example 9 | (X)-1 [65] | (B1)-2 [21] | (BS)-1 [14] | (C)-1 [15] | (E)-1 [0.05] | (S)-2 [245] |
| Example 10 | (X)-1 [65] | (B1)-2 [21] | (BS)-1 [14] | (C)-1 [20] | (E)-1 [0.05] | (S)-2 [245] |
| Example 11 | (X)-1 [65] | (B1)-2 [21] | (BS)-1 [14] | (C)-1 [30] | (E)-1 [0.05] | (S)-2 [245] |
| Example 12 | (X)-1 [65] | (B1)-2 [14] | (BS)-1 [21] | (C)-1 [15] | (E)-1 [0.05] | (S)-2 [245] |
| Example 13 | (X)-1 [65] | (B1)-2 [14] | (BS)-1 [21] | (C)-1 [20] | (E)-1 [0.05] | (S)-2 [245] |
| Example 14 | (X)-1 [65] | (B1)-2 [14] | (BS)-1 [21] | (C)-1 [30] | (E)-1 [0.05] | (S)-2 [245] |
| Example 15 | (X)-1 [72.5] | (B1)-1 [12.5] | (BS)-1 [15] | (C)-1 [10] | (E)-1 [0.05] | (S)-2 [245] |

**[Table 2]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Example 16 | (X)-1 [72.5] | (B1)-1 [12.5] | (BS)-1 [15] | (C)-1 [15] | (E)-1 [0.05] | (S)-2 [245] |
| Example 17 | (X)-1 [72.5] | (B1)-1 [11.5] | (BS)-1 [16] | (C)-1 [10] | (E)-1 [0.05] | (S)-2 [245] |
| Example 18 | (X)-1 [72.5] | (B1)-1 [11.5] | (BS)-1 [16] | (C)-1 [15] | (E)-1 [0.05] | (S)-2 [245] |
| Example 19 | (X)-1 [72.5] | (B1)-1 [9.3] | (BS)-1 [18.2] | (C)-1 [10] | (E)-1 [0.05] | (S)-2 [245] |
| Example 20 | (X)-1 [72.5] | (B1)-1 [9.3] | (BS)-1 [18.2] | (C)-1 [15] | (E)-1 [0.05] | (S)-2 [245] |
| Example 21 | (X)-1 [72.5] | (B1)-1 [9.3] | (BS)-1 [18.2] | (C)-2 [15] | (E)-1 [0.05] | (S)-2 [245] |
| Example 22 | (X)-1 [72.5] | (B1)-1 [9.3] | (BS)-1 [18.2] | (C)-3 [15] | (E)-1 [0.05] | (S)-2 [245] |
| Example 23 | (X)-2 [70] | (B1)-1 [15] | (BS)-1 [15] | (C)-1 [10] | (E)-1 [0.05] | (S)-1 [245] |
| Example 24 | (X)-2 [70] | (B1)-1 [15] | (BS)-1 [15] | (C)-1 [15] | (E)-1 [0.05] | (S)-1 [245] |
| Example 25 | (X)-2 [70] | (B1)-1 [15] | (BS)-1 [15] | (C)-1 [20] | (E)-1 [0.05] | (S)-1 [245] |
| Example 26 | (X)-2 [70] | (B1)-1 [15] | (BS)-1 [15] | (C)-2 [10] | (E)-1 [0.05] | (S)-1 [245] |
| Example 27 | (X)-2 [70] | (B1)-1 [15] | (BS)-1 [15] | (C)-2 [15] | (E)-1 [0.05] | (S)-1 [245] |
| Example 28 | (X)-2 [70] | (B1)-1 [15] | (BS)-1 [15] | (C)-2 [20] | (E)-1 [0.05] | (S)-1 [245] |
| Example 29 | (X)-2 [70] | (B1)-1 [15] | (BS)-1 [15] | (C)-3 [10] | (E)-1 [0.05] | (S)-1 [245] |
| Example 30 | (X)-2 [70] | (B1)-1 [15] | (BS)-1 [15] | (C)-3 [15] | (E)-1 [0.05] | (S)-1 [245] |

**[Table 3]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Example 31 | (X)-2 [70] | (B1)-1 [15] | (BS)-1 [15] | (C)-3 [20] | (E)-1 [0.05] | (S)-1 [245] |
| Example 32 | (X)-1 [72] | (B1)-2 [14] | (BS)-1 [14] | (C)-2 [10] | (E)-1 [0.05] | (S)-2 [245] |
| Example 33 | (X)-1 [72] | (B1)-2 [14] | (BS)-1 [14] | (C)-2 [15] | (E)-1 [0.05] | (S)-2 [245] |
| Example 34 | (X)-1 [72] | (B1)-2 [14] | (BS)-1 [14] | (C)-2 [20] | (E)-1 [0.05] | (S)-2 [245] |
| Example 35 | (X)-1 [72] | (B1)-2 [14] | (BS)-1 [14] | (C)-2 [25] | (E)-1 [0.05] | (S)-2 [245] |
| Example 36 | (X)-1 [72] | (B1)-2 [14] | (BS)-1 [14] | (C)-3 [10] | (E)-1 [0.05] | (S)-2 [245] |
| Example 37 | (X)-1 [72] | (B1)-2 [14] | (BS)-1 [14] | (C)-3 [20] | (E)-1 [0.05] | (S)-2 [245] |
| Example 38 | (X)-1 [72] | (B1)-2 [14] | (BS)-1 [14] | (C)-3 [25] | (E)-1 [0.05] | (S)-2 [245] |
| Example 39 | (X)-1 [72] | (B1)-2 [14] | (BS)-1 [14] | (C)-3 [30] | (E)-1 [0.05] | (S)-2 [245] |
| Example 40 | (X)-3 [60] | (B1)-1 [20] | (BS)-1 [20] | (C)-1 [10] | (E)-1 [0.25] | (S)-2 [245] |
| Example 41 | (X)-3 [60] | (B1)-1 [20] | (BS)-1 [20] | (C)-1 [15] | (E)-1 [0.25] | (S)-2 [245] |
| Example 42 | (X)-3 [60] | (B1)-1 [20] | (BS)-1 [20] | (C)-1 [20] | (E)-1 [0.25] | (S)-2 [245] |
| Example 43 | (X)-3 [60] | (B1)-1 [20] | (BS)-1 [20] | (C)-2 [10] | (E)-1 [0.25] | (S)-2 [245] |
| Example 44 | (X)-3 [60] | (B1)-1 [20] | (BS)-1 [20] | (C)-2 [15] | (E)-1 [0.25] | (S)-2 [245] |
| Example 45 | (X)-3 [60] | (B1)-1 [20] | (BS)-1 [20] | (C)-2 [20] | (E)-1 [0.25] | (S)-2 [245] |

**[Table 4]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Example 46 | (X)-3 [60] | (B1)-1 [20] | (BS)-1 [20] | (C)-3 [10] | (E)-1 [0.25] | (S)-2 [245] |
| Example 47 | (X)-3 [60] | (B1)-1 [20] | (BS)-1 [20] | (C)-3 [15] | (E)-1 [0.25] | (S)-2 [245] |
| Example 48 | (X)-3 [60] | (B1)-1 [20] | (BS)-1 [20] | (C)-3 [20] | (E)-1 [0.25] | (S)-2 [245] |
| Example 49 | (X)-3 [60] | (B1)-2 [40] | - | (C)-3 [10] | (E)-1 [0.25] | (S)-2 [245] |
| Example 50 | (X)-3 [60] | (B1)-2 [40] | - | (C)-3 [15] | (E)-1 [0.25] | (S)-2 [245] |
| Example 51 | (X)-3 [60] | (B1)-1 [40] | - | (C)-3 [10] | (E)-1 [0.25] | (S)-2 [245] |
| Example 52 | (X)-3 [60] | (B1)-1 [40] | - | (C)-3 [15] | (E)-1 [0.25] | (S)-2 [245] |
| Example 53 | (X)-3 [60] | (B1)-1 [40] | - | (C)-3 [20] | (E)-1 [0.25] | (S)-2 [245] |
| Example 54 | (X)-3 [60] | (B1)-1 [40] | - | (C)-3 [30] | (E)-1 [0.25] | (S)-2 [245] |
| Example 55 | (X)-3 [60] | (B1)-1 [40] | - | (C)-3 [50] | (E)-1 [0.25] | (S)-2 [245] |
| Example 56 | (X)-4 [65] | (B1)-1 [10] | (BS)-1 [25] | (C)-3 [10] | (E)-1 [0.05] | (S)-1 [245] |
| Example 57 | (X)-4 [65] | (B1)-1 [10] | (BS)-1 [25] | (C)-3 [15] | (E)-1 [0.05] | (S)-1 [245] |
| Example 58 | (X)-4 [65] | (B1)-1 [10] | (BS)-1 [25] | (C)-3 [30] | (E)-1 [0.05] | (S)-1 [245] |

**[Table 5]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Comparative Example 1 | (X)-1 [72] | (B1)-2 [14] | (BS)-1 [14] | (C)-1 [1.5] | (E)-1 [0.05] | (S)-2 [245] |
| Comparative Example 2 | (X)-1 [72] | (B1)-2 [14] | (BS)-1 [14] | (C)-1 [5] | (E)-1 [0.05] | (S)-2 [245] |
| Comparative Example 3 | (X)-1 [72] | (B1)-2 [14] | (BS)-1 [14] | (C)-1 [9] | (E)-1 [0.05] | (S)-2 [245] |
| Comparative Example 4 | (X)-1 [70] | (B1)-2 [16] | (BS)-1 [14] | (C)-1 [9] | (E)-1 [0.05] | (S)-2 [245] |
| Comparative Example 5 | (X)-1 [65] | (B1)-2 [21] | (BS)-1 [14] | (C)-1 [9] | (E)-1 [0.05] | (S)-2 [245] |
| Comparative Example 6 | (X)-1 [65] | (B1)-2 [14] | (BS)-1 [21] | (C)-1 [9] | (E)-1 [0.05] | (S)-2 [245] |
| Comparative Example 7 | (X)-2 [70] | (B1)-1 [15] | (BS)-1 [15] | (C)-1 [1.5] | (E)-1 [0.05] | (S)-1 [245] |
| Comparative Example 8 | (X)-2 [70] | (B1)-1 [15] | (BS)-1 [15] | (C)-1 [5] | (E)-1 [0.05] | (S)-1 [245] |
| Comparative Example 9 | (X)-2 [70] | (B1)-1 [15] | (BS)-1 [15] | (C)-1 [9] | (E)-1 [0.05] | (S)-1 [245] |
| Comparative Example 10 | (X)-2 [70] | (B1)-1 [15] | (BS)-1 [15] | (C)-2 [9] | (E)-1 [0.05] | (S)-1 [245] |
| Comparative Example 11 | (X)-2 [70] | (B1)-1 [15] | (BS)-1 [15] | (C)-3 [9] | (E)-1 [0.05] | (S)-1 [245] |
| Comparative Example 12 | (X)-1 [72.5] | (B1)-1 [12.5] | (BS)-1 [15] | (C)-1 [9] | (E)-1 [0.05] | (S)-2 [245] |
| Comparative Example 13 | (X)-1 [72.5] | (B1)-1 [11.5] | (BS)-1 [16] | (C)-1 [9] | (E)-1 [0.05] | (S)-2 [245] |
| Comparative Example 14 | (X)-1 [72.5] | (B1)-1 [9.3] | (BS)-1 [18.2] | (C)-1 [1.5] | (E)-1 [0.05] | (S)-2 [245] |
| Comparative Example 15 | (X)-1 [72.5] | (B1)-1 [9.3] | (BS)-1 [18.2] | (C)-1 [9] | (E)-1 [0.05] | (S)-2 [245] |

**[Table 6]**

| | Metal oxide nanoparticles | Photopolymerizable monomer | | Photopolymerizable initiator | Surfactant | Solvent |
|---|---|---|---|---|---|---|
| | Component (X) | Component (B1) | Component (BS) | Component (C) | Component (E) | Component (S) |
| Comparative Example 16 | (X)-1 [72.5] | (B1)-1 [9.3] | (BS)-1 [18.2] | (C)-2 [9] | (E)-1 [0.05] | (S)-2 [245] |
| Comparative Example 17 | (X)-1 [72.5] | (B1)-1 [9.3] | (BS)-1 [18.2] | (C)-3 [9] | (E)-1 [0.05] | (S)-2 [245] |
| Comparative Example 18 | (X)-1 [72] | (B1)-2 [14] | (BS)-1 [14] | (C)-2 [9] | (E)-1 [0.05] | (S)-2 [245] |
| Comparative Example 19 | (X)-1 [72] | (B1)-2 [14] | (BS)-1 [14] | (C)-3 [9] | (E)-1 [0.05] | (S)-2 [245] |
| Comparative Example 20 | (X)-3 [60] | (B1)-1 [20] | (BS)-1 [20] | (C)-1 [5] | (E)-1 [0.25] | (S)-2 [245] |
| Comparative Example 21 | (X)-3 [60] | (B1)-1 [20] | (BS)-1 [20] | (C)-2 [5] | (E)-1 [0.25] | (S)-2 [245] |
| Comparative Example 22 | (X)-3 [60] | (B1)-1 [20] | (BS)-1 [20] | (C)-3 [5] | (E)-1 [0.25] | (S)-2 [245] |
| Comparative Example 23 | (X)-3 [60] | (B1)-2 [40] | - | (C)-3 [5] | (E)-1 [0.25] | (S)-2 [245] |
| Comparative Example 24 | (X)-3 [60] | (B1)-1 [40] | - | (C)-3 [7.5] | (E)-1 [0.25] | (S)-2 [245] |
| Comparative Example 25 | (X)-4 [65] | (B1)-1 [10] | (BS)-1 [25] | (C)-3 [7.5] | (E)-1 [0.05] | (S)-1 [245] |

In Tables 1 to 6, each abbreviation has the following meaning. The numerical values in the brackets are blending amounts (parts by mass).

### • Component (X) (metal oxide nanoparticles)

(X)-1: Titania particles, product name "ELECOM V-9108" manufactured by JGC Catalysts and Chemicals Ltd. Volume-average primary particle diameter of 15 nm.
(X)-2: Titania particles, product name "NS405" manufactured by Tayca Corporation. Volume-average primary particle diameter of 15 nm.
(X)-3: Titania particles, product name "LDB-014-35" manufactured by Ishihara Sangyo Kaisha, Ltd. Volume-average primary particle diameter of 15 nm.
(X)-4: Zirconia particles, product name "UEP-100" manufactured by Daiichi Kigenso Kagaku Kogyo Co., Ltd. Volume-average primary particle diameter of 15 nm.

### • Component (B) (photopolymerizable compound)

(B1)-1: Polyfunctional acrylate, product name "KAYARAD DPHA" manufactured by Nippon Kayaku Co., Ltd.
(B1)-2: Trimethylolpropane triacrylate, product name "LIGHT ACRYLATE TMP-A" manufactured by Kyoeisha Chemical Co., Ltd.
(BS)-I: Bis(4-methacryloylthiophenyl) sulfide, product code "B1662" manufactured by Tokyo Chemical Industry Co., Ltd.

### • Component (C) (photoradical polymerization initiator)

(C)-1: 2,2-Dimethoxy-2-phenylacetophenone, product name "Omnirad 651" manufactured by IGM Resins B. V. Molecular weight of 256.3
(C)-2: Bis(2,4,6-trimethylbenzoyl)-phenylphosphine oxide, product name "Omnirad 819" manufactured by IGM Resins B. V. Molecular weight of 418.5.
(C)-3: 1-Hydroxycyclohexylphenyl ketone, product name "Omnirad 184" manufactured by IGM Resins B. V. Molecular weight of 204.3.

### • Component (E)

(E)-1: Fluorine-based surfactant, product name "PolyFox PF656" manufactured by OMNOVA Solutions Inc.

• Component (S) (solvent)
(S)-1: Propylene glycol monomethyl ether acetate (PGMEA)
(S)-2: Propylene glycol monomethyl ether (PGME)

### <Evaluation>

The imprint transferability, the refractive index, and the haze of the photocurable composition of each of Examples and Comparative Examples were evaluated by each of the following methods described below. Results thereof are shown in Tables 7 to 12.

### [Imprint Transferability]

The photocurable composition was applied onto a silicon substrate by spin coating such that the film thickness was adjusted to 600 nm. Next, prebaking was performed at 100°C for 1 minute, a transfer test was performed at a transfer pressure of 0.5 MPa and an exposure amount of 1 J/cm² (in a vacuum atmosphere of 200 Pa) for a transfer time of 30 seconds, using an imprint device ST-200 manufactured by Shibaura Machine Co., Ltd., and the transferability and the filling property of the fine pattern were evaluated based on the following evaluation criteria. A standard film mold LSP70-140 (70 nm Line & Space) manufactured by Soken Chemical Co., Ltd. was used as the mold.
Good: 95% or more (in a case of confirmation using an SEM, the mold was filled 100% and the pattern was able to be transferred)
Poor: Less than 95%

### [Refractive Index]

The photocurable composition was applied onto a silicon substrate by spin coating such that the film thickness was adjusted to 600 nm. Next, prebaking was performed at 100°C for 1 minute and a photocuring treatment was performed at an exposure amount of 1 J/cm² (in a vacuum atmosphere of 200 Pa) using an imprint device ST-200 manufactured by Shibaura Machine Co., Ltd. to obtain a cured film. The refractive index of the obtained cured film at a wavelength of 530 nm was measured using a spectroscopic ellipsometer M2000 manufactured by J. A. Woollam Co., Inc.

### [Haze]

The photocurable composition was applied onto an Eagle X glass substrate by spin coating such that the thickness was adjusted to 600 nm. Next, prebaking was performed at 100°C for 1 minute and a photocuring treatment was performed at an exposure amount of 1 J/cm² (in a vacuum atmosphere of 200 Pa) using an imprint device ST-200 manufactured by Shibaura Machine Co., Ltd. to obtain a cured film. The haze of the obtained cured film was measured with a C light source (380 to 780 nm), using a haze meter COH 7700 manufactured by Nippon Denshoku Industries Co., Ltd.

**[Table 7]**

| | Imprint transferability | Refractive index (wavelength: 530 nm) | Haze [%] |
|---|---|---|---|
| Example 1 | Good | 1.78 | 0.4 |
| Example 2 | Good | 1.78 | 0.3 |
| Example 3 | Good | 1.77 | 0.2 |
| Example 4 | Good | 1.75 | 0.2 |
| Example 5 | Good | 1.70 | 0.2 |
| Example 6 | Good | 1.77 | 0.4 |
| Example 7 | Good | 1.76 | 0.3 |
| Example 8 | Good | 1.75 | 0.2 |
| Example 9 | Good | 1.72 | 0.4 |
| Example 10 | Good | 1.72 | 0.3 |
| Example 11 | Good | 1.71 | 0.2 |
| Example 12 | Good | 1.74 | 0.4 |
| Example 13 | Good | 1.74 | 0.4 |
| Example 14 | Good | 1.73 | 0.3 |
| Example 15 | Good | 1.78 | 0.4 |

**[Table 8]**

| | Imprint transferability | Refractive index (wavelength: 530 nm) | Haze [%] |
|---|---|---|---|
| Example 16 | Good | 1.78 | 0.3 |
| Example 17 | Good | 1.78 | 0.4 |
| Example 18 | Good | 1.78 | 0.3 |
| Example 19 | Good | 1.80 | 0.4 |
| Example 20 | Good | 1.80 | 0.3 |
| Example 21 | Good | 1.80 | 0.4 |
| Example 22 | Good | 1.80 | 0.3 |
| Example 23 | Good | 1.80 | 0.4 |
| Example 24 | Good | 1.80 | 0.2 |
| Example 25 | Good | 1.80 | 0.2 |
| Example 26 | Good | 1.80 | 0.4 |
| Example 27 | Good | 1.80 | 0.3 |
| Example 28 | Good | 1.80 | 0.3 |
| Example 29 | Good | 1.80 | 0.3 |
| Example 30 | Good | 1.80 | 0.2 |

**[Table 9]**

| | Imprint transferability | Refractive index (wavelength: 530 nm) | Haze [%] |
|---|---|---|---|
| Example 31 | Good | 1.80 | 0.2 |
| Example 32 | Good | 1.78 | 0.3 |
| Example 33 | Good | 1.78 | 0.3 |
| Example 34 | Good | 1.77 | 0.2 |
| Example 35 | Good | 1.75 | 0.2 |
| Example 36 | Good | 1.78 | 0.4 |
| Example 37 | Good | 1.77 | 0.2 |
| Example 38 | Good | 1.76 | 0.1 |
| Example 39 | Good | 1.75 | 0.1 |
| Example 40 | Good | 1.78 | 0.3 |
| Example 41 | Good | 1.77 | 0.3 |
| Example 42 | Good | 1.77 | 0.2 |
| Example 43 | Good | 1.78 | 0.4 |
| Example 44 | Good | 1.77 | 0.4 |
| Example 45 | Good | 1.77 | 0.3 |

**[Table 10]**

| | Imprint transferability | Refractive index (wavelength: 530 nm) | Haze [%] |
|---|---|---|---|
| Example 46 | Good | 1.78 | 0.3 |
| Example 47 | Good | 1.77 | 0.3 |
| Example 48 | Good | 1.77 | 0.2 |
| Example 49 | Good | 1.72 | 0.4 |
| Example 50 | Good | 1.71 | 0.3 |
| Example 51 | Good | 1.73 | 0.4 |
| Example 52 | Good | 1.72 | 0.3 |
| Example 53 | Good | 1.72 | 0.2 |
| Example 54 | Good | 1.71 | 0.2 |
| Example 55 | Good | 1.70 | 0.1 |
| Example 56 | Good | 1.77 | 0.4 |
| Example 57 | Good | 1.77 | 0.2 |
| Example 58 | Good | 1.75 | 0.1 |

**[Table 11]**

| | Imprint transferability | Refractive index (wavelength: 530 nm) | Haze [%] |
|---|---|---|---|
| Comparative Example 1 | Good | 1.79 | 0.6 |
| Comparative Example 2 | Good | 1.79 | 0.5 |
| Comparative Example 3 | Good | 1.79 | 0.5 |
| Comparative Example 4 | Good | 1.78 | 0.5 |
| Comparative Example 5 | Good | 1.73 | 0.5 |
| Comparative Example 6 | Good | 1.74 | 0.6 |
| Comparative Example 7 | Good | 1.81 | 0.7 |
| Comparative Example 8 | Good | 1.81 | 0.5 |
| Comparative Example 9 | Good | 1.80 | 0.5 |
| Comparative Example 10 | Good | 1.80 | 0.6 |
| Comparative Example 11 | Good | 1.80 | 0.5 |
| Comparative Example 12 | Good | 1.78 | 0.5 |
| Comparative Example 13 | Good | 1.78 | 0.6 |
| Comparative Example 14 | Good | 1.80 | 0.8 |
| Comparative Example 15 | Good | 1.80 | 0.5 |

**[Table 12]**

| | Imprint transferability | Refractive index (wavelength: 530 nm) | Haze [%] |
|---|---|---|---|
| Comparative Example 17 | Good | 1.80 | 0.5 |
| Comparative Example 18 | Good | 1.78 | 0.5 |
| Comparative Example 19 | Good | 1.78 | 0.5 |
| Comparative Example 20 | Good | 1.77 | 0.5 |
| Comparative Example 21 | Good | 1.77 | 0.7 |
| Comparative Example 22 | Good | 1.77 | 0.5 |
| Comparative Example 23 | Good | 1.74 | 0.5 |
| Comparative Example 24 | Good | 1.73 | 0.5 |
| Comparative Example 25 | Good | 1.78 | 0.6 |

As shown from the results of Tables 7 to 12, the photocurable compositions of Examples 1 to 58 had a high refractive index with a refractive index of 1.70 or higher. In addition, the haze value was reduced to 0.4% or less. On the other hand, the photocurable compositions of Comparative Examples 1 to 25 had a refractive index of 1.70 or more, but had a haze value of 0.5% or more.

From these results, it was confirmed that the photocurable compositions of the Examples can reduce haze, as compared with the photocurable compositions of the Comparative Examples, while maintaining a high refractive index.

Although preferred Examples of the present invention have been described above, the present invention is not limited to these Examples. Addition, omission, replacement, and other modifications can be made to the configuration without departing from the spirit of the present invention. The present invention is not limited by the descriptions above, but only by the scope of the accompanying claims.

### [Reference Signs List]

1: Substrate
2: Photocurable film
3: Mold

## Claims

1. A photocurable composition, comprising:
metal oxide nanoparticles (X);
a photopolymerizable compound (B); and
a photoradical polymerization initiator (C),
wherein the content of the photoradical polymerization initiator (C) is 10 parts by mass or more with respect to 100 parts by mass of the total content of the metal oxide nanoparticles (X) and the photopolymerizable compound (B).

2. The photocurable composition according to Claim 1,
wherein the metal oxide nanoparticles (X) have a volume-average primary particle diameter of 100 nm or less.

3. The photocurable composition according to Claim 1 or 2,
wherein the content of the metal oxide nanoparticles (X) is 60 to 90 parts by mass and the content of the photopolymerizable compound (B) is 10 to 40 parts by mass, with respect to 100 parts by mass of the total content of the metal oxide nanoparticle (X) and the photopolymerizable compound (B).

4. The photocurable composition according to any one of Claims 1 to 3,
wherein a cured film formed of the photocurable composition has a refractive index of 1.70 or more at a wavelength of 530 nm.

5. The photocurable composition according to any one of Claims 1 to 4,
wherein a cured film having a film thickness of 600 nm, which is formed of the photocurable composition, has a haze value of 0.4% or less as measured in accordance with ASTMD100.

6. The photocurable composition according to any one of Claims 1 to 5,
wherein the photocurable composition is used for optical imprint lithography.

7. A pattern-forming method, comprising:
a step of forming a photocurable film on a substrate using the photocurable composition according to any one of Claims 1 to 6;
a step of pressing a mold having an uneven pattern against the photocurable film to transfer the uneven pattern to the photocurable film;
a step of exposing the photocurable film to which the uneven pattern has been transferred while pressing the mold against the photocurable film to form a cured film; and
a step of peeling off the mold from the cured film.
